# EUROPEAN PATENT APPLICATION

(11) **EP 4 796 943 A1**
(43) Date of publication of application: **26.08.2026**
(21) Application number: 25749041.7
(22) Date of filing: 24.01.2025
(51) Int. Cl.: G01R 31/392, G01R 31/382, G01R 31/396, G01R 33/14, G01R 19/10, G01R 19/165, G01R 31/367, B60L 58/16

(54) **BATTERY MANAGEMENT APPARATUS AND BATTERY MANAGEMENT METHOD**

(30) Priority: 31.01.2024 KR 20240015098
(71) Applicant: LG Energy Solution, Ltd., Seoul 07335 (KR)
(72) Inventor: YUK, Young-Ji, Daejeon 34122 (KR); CHOI, Soon-Ju, Daejeon 34122 (KR); KIM, Dae-Soo, Daejeon 34122 (KR)
(74) Representative: Goddar, Heinz J.
(86) International application number: PCT/KR2025/001550
(87) International publication number: WO 2025/165138

(57) **Abstract**

A battery management apparatus according to the present disclosure includes a profile obtaining unit configured to obtain a charge profile and a discharge profile representing a charge and discharge characteristic of a battery; and a diagnosing unit configured to calculate a hysteresis characteristic value based on voltage difference information between the charge profile and the discharge profile in a target section and to compare the hysteresis characteristic value with a diagnosis value to diagnose a state of the battery.

## Description

### TECHNICAL FIELD

The present disclosure relates to a battery management apparatus and method capable of diagnosing a state of a battery.

This application is based on and claims priority from Korean Patent Application No. 10-2024-0015098, filed on January 31, 2024, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although much research is being conducted on these batteries in terms of high capacity and high density, improving lifespan and safety is also important. In order to improve battery safety, a technology that accurately diagnoses the current state of the battery is required.

In the ideal charge and discharge cycle of a battery, the charge capacity and discharge capacity may be the same, but in the actual charge and discharge cycle of the battery, the charge capacity and discharge capacity may differ due to factors such as internal resistance. In other words, the battery has a hysteresis characteristic in which the charge characteristic and discharge characteristic differ in the actual charge and discharge cycle. The hysteresis characteristic is derived from the difference between the phase transition voltage that occurs when the battery is charged and the phase transition voltage that occurs when the battery is discharged. The hysteresis phenomenon may appear more distinctly as the battery degrades or the charge/discharge rate (C-rate) is higher. Therefore, it is required to develop a technology that can determine the parameter representing the hysteresis characteristic of the battery and diagnose the degradation state of the battery based on the determined parameter.

In addition, if charge and discharge characteristics for SOC 0% to 100% sections are essential for diagnosing the degradation state of a battery, the diagnosis may take an unnecessarily long time. Therefore, in order to shorten the diagnosis time, development of a technology capable of diagnosing the degradation state with only charge and discharge characteristics for some capacity sections (or SOC sections) is required.

### DISCLOSURE

### Technical Problem

The present disclosure is designed to solve the problems of the related art, and therefore the present disclosure is directed to providing a battery management apparatus and method capable of diagnosing a degradation state of a battery based on a hysteresis characteristic value, which is a parameter representing the hysteresis characteristic of a battery.

In addition, the present disclosure aims to provide a battery management apparatus and method that can diagnose the state of a battery with only charge and discharge characteristics for a partial capacity section (or SOC section) of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure comprises: a profile obtaining unit configured to obtain a charge profile and a discharge profile representing a charge and discharge characteristic of a battery; and a diagnosing unit configured to calculate a hysteresis characteristic value based on voltage difference information between the charge profile and the discharge profile in a target section and to compare the hysteresis characteristic value with a diagnosis value to diagnose a state of the battery.

The diagnosing unit may be configured to determine the target section by comparing a capacity range of the charge profile with a capacity range of the discharge profile.

The diagnosing unit may be configured to determine all or part of a capacity section common to the charge profile and the discharge profile as the target section.

The target section may be predetermined.

The diagnosing unit may be configured to calculate the hysteresis characteristic value based on an integral of a voltage difference between a voltage of the charge profile and a voltage of the discharge profile for the target section.

The battery management apparatus may further comprise a storage unit.

The storage unit may store a lookup table in which a plurality of reference capacity sections and a plurality of diagnosis values are mapped one-to-one.

The diagnosing unit may determine a reference value mapped to one reference capacity section corresponding to the target section among the plurality of reference capacity sections as the diagnosis value.

The diagnosing unit may be configured to calculate the diagnosis value based on a preset reference charge profile and a preset reference discharge profile.

The diagnosing unit may be configured to determine the diagnosis value based on an integral of a voltage difference between a voltage of the reference charge profile and a voltage of the discharge profile for the target section.

The diagnosing unit may diagnose the state of the battery as a normal state when a difference between the hysteresis characteristic value and the diagnosis value is less than a preset first threshold value.

The diagnosing unit may diagnose the state of the battery as an abnormal state when the difference between the hysteresis characteristic value and the diagnosis value is greater than or equal to the first threshold value.

The diagnosing unit may diagnose the state of the battery as a normal state when a ratio of the hysteresis characteristic value to the diagnosis value is less than a preset second threshold value.

The diagnosing unit may diagnose the state of the battery as an abnormal state when the ratio of the hysteresis characteristic value to the diagnosis value is greater than or equal to the preset second threshold value.

The battery management apparatus may further comprise a control unit.

The control unit may be configured to set a usage condition for the battery based on the diagnosis result.

A battery pack according to another aspect of the present disclosure comprises the battery management apparatus according to one aspect of the present disclosure.

A vehicle according to still another aspect of the present disclosure comprises the battery management apparatus according to one aspect of the present disclosure.

A battery management method according to still another aspect of the present disclosure may comprise: obtaining a charge profile and a discharge profile representing a charge and discharge characteristic of a battery; calculating a hysteresis characteristic value based on voltage difference information between the charge profile and the discharge profile in a target section; and comparing the hysteresis characteristic value with a diagnosis value to diagnose a state of the battery.

### Advantageous Effects

According to at least one of the embodiments of the present disclosure, the degradation state of a battery can be diagnosed based on a hysteresis characteristic value, which is a parameter representing the hysteresis characteristic of the battery.

In addition, according to at least one of the embodiments of the present disclosure, the time required for diagnosis can be shortened by diagnosing the state of the battery only with the charge and discharge characteristics for some capacity section (or SOC section) of the battery.

In addition, according to at least one of the embodiments of the present disclosure, degradation or accelerated degradation of the battery can be prevented by appropriately setting the usage condition of the battery based on the state diagnosis result for the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating a battery management apparatus according to an embodiment of the present disclosure.
FIG. 2 is a diagram schematically illustrating an example of a charge profile and a discharge profile.
FIG. 3 is a drawing illustrating an exemplary configuration of a battery pack according to another embodiment of the present disclosure.
FIG. 4 is a drawing schematically illustrating an exemplary configuration of a vehicle according to still another embodiment of the present disclosure.
FIG. 5 is a drawing schematically illustrating a battery management method according to still another embodiment of the present disclosure.
FIG. 6 is a drawing schematically illustrating a battery management method according to still another embodiment of the present disclosure.

### BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a most preferred example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the attached drawings.

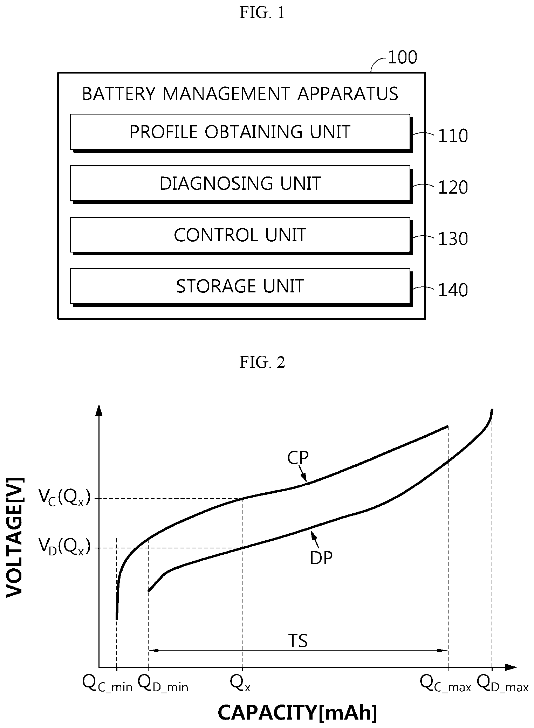

FIG. 1 is a diagram schematically illustrating a battery management apparatus 100 according to an embodiment of the present disclosure.

Referring to FIG. 1, a battery management apparatus 100 according to an embodiment of the present disclosure may include a profile obtaining unit 110 and a diagnosing unit 120, and may further include a control unit 130. The battery management apparatus 100 may further include a storage unit 140.

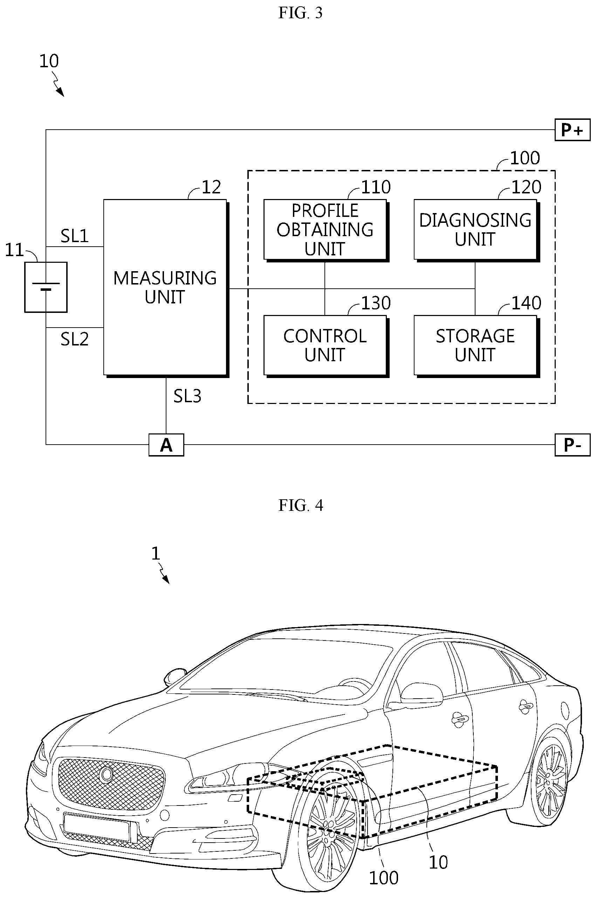

The battery management apparatus 100 is provided to diagnose the state of a battery (see symbol 11 of FIG. 3). Depending on the embodiment, the battery management apparatus 100 may be configured to organically link with other configurations or modules/devices, etc., to generate and output diagnostic data for the battery.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

FIG. 2 is a diagram schematically illustrating an example of a charge profile CP and a discharge profile DP.

In the embodiment of FIG. 2, the horizontal axis (X-axis) represents capacity (mAh), and the vertical axis (Y-axis) represents voltage (V).

The profile obtaining unit 110 may be configured to obtain a charge profile CP and a discharge profile DP representing charge and discharge characteristics of a battery.

The charge profile CP may represent the corresponding relationship between the voltage and the capacity (or SOC: State of Charge, resistance) in the charging process of the battery. For example, the charging process may proceed according to the CC-CV (Constant Current-Constant Voltage) charge protocol. The magnitude of the charge current used for the CC charging and the magnitude of the charge voltage used for the CV charging of the charging process may be determined in advance. The charge protocol used to periodically or non-periodically obtain the charge profile CP throughout the entire life of the battery may be the same as the charge protocol used to obtain the reference charge profile to be described later. If the capacity-voltage characteristic during battery charging can be obtained, the type of the charge protocol is not limited to the CC-CV charge protocol.

And, the discharge profile DP may represent the corresponding relationship between the voltage and the capacity (or SOC, resistance) in the discharging process of the battery. For example, the discharging process may proceed according to a CC (Constant Current) discharge protocol. The magnitude of the discharge current used for the CC discharge of the discharging process may be determined in advance. The discharge protocol used to periodically or non-periodically obtain the discharge profile DP throughout the entire life of the battery may be the same as the discharge protocol used to obtain the reference discharge profile to be described later. If the capacity-voltage characteristic during battery discharging can be obtained, the type of the discharge protocol is not limited to the CC discharge protocol.

In this specification, obtaining any data or information should be understood to mean reception from an external device, etc. through a communication means, input from a user, etc. through an input means, or creation through execution of a program, etc.

For example, the profile obtaining unit 110 may be connected to the outside by wires and/or wirelessly to directly receive the charge profile CP and the discharge profile DP. The wired communication may be, for example, CAN (controller area network) communication or CAN-FD (CAN with Flexible Data rate) communication. The wireless communication may be, for example, Zigbee or Bluetooth communication. Of course, as long as it supports communication between the profile obtaining unit 110 and the outside, the type of communication protocol is not particularly limited.

As another example, the profile obtaining unit 110 may receive measurement information representing voltage and current of the battery. Then, the profile obtaining unit 110 may generate a charge profile CP and a discharge profile DP based on the received measurement information.

For example, the profile obtaining unit 110 may generate a charge profile CP and a discharge profile DP by executing a process of mutually mapping the voltage time series and the capacity time series (or SOC time series, resistance time series) of the battery based on time indices. The charge profile CP and the discharge profile DP may be a set or polynomial of data points representing the corresponding relationship between the voltage and the capacity (or SOC, resistance) of the battery. Each data point of the charge profile CP and the discharge profile DP may be a pair of a voltage value and a capacity value (or SOC, resistance value) indexed at the same point in time (the same measurement timing).

The voltage time series may represent the change history of the voltage over time of the battery. The current time series may represent the change history of the current over time of the battery. The capacity time series (or SOC time series) may be determined by applying ampere counting to the current time series. The resistance time series may be determined by applying Ohm's law to the voltage and current of the battery.

SOC is a parameter that represents the current capacity with respect to the maximum capacity as 0% to 100%, and may be calculated through various techniques such as current integration, equivalent circuit model, and Kalman filter. Depending on the embodiment, the battery management apparatus 100 may be configured to generate information on SOC by further reflecting environmental information such as temperature information.

The profile obtaining unit 110 may be connected to the diagnosing unit 120 so as to be communicatively connected. For example, the profile obtaining unit 110 may be connected to the diagnosing unit 120 in a wired and/or wireless manner. The profile obtaining unit 110 may transmit the obtained charge profile CP and discharge profile DP to the diagnosing unit 120.

The diagnosing unit 120 may be configured to calculate a hysteresis characteristic value based on voltage difference information between the charge profile CP and the discharge profile DP in the target section. A time interval between an end time of one of the charging process and the discharging process and a start time of the other process performed to obtain the charge profile CP and the discharge profile DP used for calculating the hysteresis characteristic value may be less than a predetermined threshold time. For example, the time interval between the end time of the charging process in which the charge profile CP is obtained and the start time of the discharging process in which the discharge profile DP is obtained may be less than the threshold time. In this case, the corresponding discharging process may be performed after the corresponding charging process. As another example, the time interval between the end time of the discharging process in which the discharge profile DP is obtained and the start time of the charging process in which the charge profile CP is obtained may be less than the threshold time. In this case, the corresponding charging process may be performed after the corresponding discharging process.

Together with or separately from this, the charge and discharge capacity of the battery during the time between the end time of one of the charging process and the start time of the other process may be less than the threshold capacity.

In one embodiment, the diagnosing unit 120 may be configured to determine the target section TS by comparing the capacity range (or SOC range, resistance range) of the charge profile CP with the capacity range (or SOC range, resistance range) of the discharge profile DP.

The target section TS may be all or part of a capacity section common to the charge profile CP and the discharge profile DP. For example, the diagnosing unit 120 may determine a larger value between the minimum capacity of the charge profile CP and the minimum capacity of the discharge profile DP as the lower limit value of the target section TS. If the minimum capacity of the charge profile CP and the minimum capacity of the discharge profile DP are the same, the diagnosing unit 120 may determine the minimum capacity of the charge profile CP or the minimum capacity of the discharge profile DP as the lower limit value of the target section TS.

And, the diagnosing unit 120 may determine a smaller value between the maximum capacity of the charge profile CP and the maximum capacity of the discharge profile DP as the upper limit value of the target section TS. If the maximum capacity of the charge profile CP and the maximum capacity of the discharge profile DP are the same, the diagnosing unit 120 may determine the maximum capacity of the charge profile CP or the maximum capacity of the discharge profile DP as the upper limit value of the target section TS.

In the embodiment of FIG. 2, the diagnosing unit 120 may determine the minimum capacity (Q_{C_min}) and the maximum capacity (Q_{C_max}) of the charge profile CP, and determine the minimum capacity (Q_{D_min}) and the maximum capacity (Q_{D_max}) of the discharge profile DP. In addition, the diagnosing unit 120 may determine the maximum value (Q_{D_min}) among the minimum capacity (Q_{C_min}) of the charge profile CP and the minimum capacity (Q_{D_min}) of the discharge profile DP as the lower limit value of the target section TS. The diagnosing unit 120 may determine the minimum value (Q_{C_max}) among the maximum capacity (Q_{C_max}) of the charge profile CP and the maximum capacity (QD_max) of the discharge profile DP as the upper limit value of the target section TS. That is, the diagnosing unit 120 may determine the capacity section of Q_{D_min} to Q_{C_max} as the target section TS.

Similarly, the diagnosing unit 120 may be configured to determine the target section TS equal to the common SOC range of the charge profile CP and the discharge profile DP. In this case, the target section TS may represent the SOC section.

If the charge profile CP and the discharge profile DP represent a corresponding relationship between the voltage and resistance of the battery, the diagnosing unit 120 may be configured to determine the target section TS equal to the common resistance range of the charge profile CP and the discharge profile DP. In this case, the target section TS may represent the resistance section.

In another embodiment, the target section TS may be predetermined. Specifically, the target section TS may be a predetermined capacity section, SOC section, or resistance section. For example, the target section TS may be a SOC section (e.g., 40% to 60%) in which the hysteresis characteristic significantly changes to a certain level or more as the battery degrades, and may be a section confirmed through a number of prior experiments.

The diagnosing unit 120 may be configured to calculate a hysteresis characteristic value based on an integral of a voltage difference between the voltage of the charge profile CP and the voltage of the discharge profile DP with respect to the target section TS. In this case, the hysteresis characteristic value represents an area of a closed curve defined by the charge profile CP, the discharge profile DP, and the target section TS, and may be defined as one of the degradation parameters used to evaluate the degradation state of the battery.

For example, the diagnosing unit 120 may calculate the voltage difference between the voltage value of the charge profile CP and the voltage value of the discharge profile DP corresponding to the same capacity within the target section TS. Then, the diagnosing unit 120 may determine the integral for the voltage difference in the target section TS as the hysteresis characteristic value.

In the embodiment of FIG. 2, the diagnosing unit 120 may calculate the voltage difference (i.e., V_{C}(Qₓ) - V_{D}(Qₓ)) between the voltage value (V_{C}(Qₓ)) of the charge profile CP and the voltage value (V_{D}(Qₓ)) of the discharge profile DP corresponding to any capacity (Qₓ) in the target section TS. Then, the diagnosing unit 120 may determine the integral for the voltage difference in the target section TS as a hysteresis characteristic value.

For example, the diagnosing unit 120 may determine the hysteresis characteristic value using the formula 1.$H = {\int }_{{Q}_{D min}}^{{Q}_{C max}} \left({V}_{C}\left(Q\right)-{V}_{D}\left(Q\right)\right) dQ$

Here, H represents the hysteresis characteristic value, V_{C}(Q) represents the corresponding voltage value when the capacity is Q in the charge profile CP, and V_{D}(Q) represents the corresponding voltage value when the capacity is Q in the discharge profile DP.

The diagnosing unit 120 may be configured to diagnose the state of the battery by comparing the hysteresis characteristic value with the diagnosis value.

The diagnosis value is a parameter to be compared with the hysteresis characteristic value of the battery, and may be determined among a plurality of preset reference values, or may be determined based on preset reference charge profile and reference discharge profile. A specific example of the diagnosing unit 120 determining the diagnosis value will be described below.

The diagnosing unit 120 may diagnose the state of the battery as a normal state or an abnormal state. Here, the abnormal state may mean a state in which the hysteresis characteristic value determined based on the charge profile CP and the discharge profile DP becomes larger than a predetermined value as the battery degrades. As the battery degrades, the internal resistance increases, and the hysteresis characteristic value and the internal resistance of the battery have a strong positive correlation. Therefore, the abnormal state may mean a state in which the internal resistance of the battery becomes larger than a predetermined value. In other words, the abnormal state may be understood as a state in which the battery is excessively degraded and appropriate control is required in order to use the battery safely and for a long period of time thereafter.

In one embodiment, the diagnosing unit 120 may diagnose the state of the battery based on the difference between the hysteresis characteristic value and the diagnosis value. For example, if the difference between the hysteresis characteristic value and the diagnosis value is less than a preset first threshold value, the diagnosing unit 120 may be configured to diagnose the state of the battery as a normal state. As another example, if the difference between the hysteresis characteristic value and the diagnosis value is greater than or equal to the first threshold value, the diagnosing unit 120 may be configured to diagnose the state of the battery as an abnormal state. The difference between the hysteresis characteristic value and the diagnosis value tends to increase as the battery degrades. Therefore, the difference between the hysteresis characteristic value and the diagnosis value may be viewed as an indicator of the degree of degradation of the battery.

In another embodiment, the diagnosing unit 120 may diagnose the state of the battery based on the ratio between the hysteresis characteristic value and the diagnosis value. For example, if the ratio of the hysteresis characteristic value to the diagnosis value is less than a preset second threshold value, the diagnosing unit 120 may be configured to diagnose the state of the battery as a normal state. As another example, if the ratio of the hysteresis characteristic value to the diagnosis value is greater than or equal to the second threshold value, the diagnosing unit 120 may be configured to diagnose the state of the battery as an abnormal state. The ratio of the hysteresis characteristic value to the diagnosis value tends to increase as the battery degrades. Therefore, the ratio of the hysteresis characteristic value to the diagnosis value may be viewed as an indicator of the degree of degradation of the battery.

The battery management apparatus 100 diagnoses the state of the battery based on the hysteresis characteristic value in the target section TS. Therefore, it is not necessary to charge and discharge the entire section (e.g., SOC 0% to 100% section) for the state diagnosis. In other words, the state of the battery may be diagnosed using only the charge and discharge characteristics for a portion of the capacity section (or SOC section) of the battery, thereby shortening the time required for the diagnosis.

Meanwhile, the profile obtaining unit 110, the diagnosing unit 120 and the control unit 130 included in the battery management apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110, the diagnosing unit 120 and the control unit 130 may be implemented as a set of program modules. At this time, the program module may be stored in the memory and executed by the profile obtaining unit 110, the diagnosing unit 120 and the control unit 130. The memory may be inside or outside battery management apparatus 100 and may be connected to the profile obtaining unit 110, the diagnosing unit 120 and the control unit 130 by various well-known means.

In addition, the battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the profile obtaining unit 110, the diagnosing unit 120 and the control unit 130 are defined.

Specifically, the storage unit 140 may store information required for the profile obtaining unit 110 to obtain the charge profile CP and the discharge profile DP. The storage unit 140 may store information required for the diagnosing unit 120 to calculate the hysteresis characteristic value. In addition, the storage unit 140 may store information required for the diagnosing unit 120 to diagnose the state of the battery by comparing the hysteresis characteristic value with the diagnosis value. For example, the storage unit 140 may store the charge profile CP, the discharge profile DP, the hysteresis characteristic value, the diagnosis value, the target section TS, the lookup table, the reference charge profile, the reference discharge profile, the first threshold value, the second threshold value, and the like. In addition, the profile obtaining unit 110, the diagnosing unit 120, and the control unit 130 may access the storage unit 140 to obtain necessary information.

Below, a specific example in which the diagnosing unit 120 determines the diagnosis value is described.

For example, the storage unit 140 may store a lookup table in which a plurality of reference capacity sections and a plurality of reference values are mapped one-to-one. The diagnosing unit 120 may be configured to determine a reference value mapped to one reference capacity section corresponding to the target section TS among the plurality of reference capacity sections as a diagnosis value.

In the embodiment of FIG. 2, the diagnosing unit 120 may determine one reference capacity section corresponding to the target section (TS, Q_{D_min} to Q_{C_max}) among the plurality of reference capacity sections of the lookup table. For example, the lower limit value of the reference capacity section may be Q_{D_min}, and the upper limit value may be Q_{C_max}. The diagnosing unit 120 may determine one reference value mapped to one reference capacity section (Q_{D_min} to Q_{C_max}) corresponding to the target section TS as the diagnosis value. That is, the diagnosing unit 120 may determine the reference value corresponding to the determined reference capacity section (Q_{D_min} to Q_{C_max}) in the lookup table as the diagnosis value.

As another example, the diagnosing unit 120 may be configured to generate a diagnosis value based on the reference charge profile and the reference discharge profile.

Specifically, the diagnosing unit 120 may be configured to determine a diagnosis value based on an integral of the voltage difference between the voltage of the reference charge profile and the voltage of the discharge profile DP with respect to the target section TS.

A reference charge profile may be a profile that represents the corresponding relationship between the voltage and capacity (or SOC, resistance) obtained during charging when a reference battery preset to correspond to the battery to be diagnosed is in the BOL (Beginning of Life) state.

A reference discharge profile may be a profile that represents the corresponding relationship between the voltage and capacity (or SOC, resistance) obtained during discharging when a reference battery preset to correspond to the battery to be diagnosed is in the BOL state.

The reference charge profile and reference discharge profile may be pre-recorded in the storage unit 140.

The method in which the diagnosing unit 120 determines the diagnosis value based on the integral of the voltage difference between the reference charge profile and the discharge profile DP with respect to the target section TS is the same as the method in which the diagnosing unit 120 determines the hysteresis characteristic value based on the integral of the voltage difference between the charge profile CP and the discharge profile DP with respect to the target section TS, as described above.

Specifically, the diagnosing unit 120 may calculate a voltage difference between the voltage value of the reference charge profile and the voltage value of the reference discharge profile corresponding to the same capacity within the target section TS. In addition, the diagnosing unit 120 may determine an integral for the voltage difference in the target section TS as the diagnosis value.

The diagnosing unit 120 may calculate the voltage difference between the voltage value of the reference charge profile and the voltage value of the discharge profile DP corresponding to any capacity (Qₓ) in the target section TS. Then, the diagnosing unit 120 may determine the integral for the voltage difference in the target section TS as the diagnosis value.

For example, the diagnosing unit 120 may determine the diagnosis value using the formula 2.$D = {\int }_{{Q}_{D min}}^{{Q}_{C max}} \left({V}_{RCP}\left(Q\right)-{V}_{RDP}\left(Q\right)\right) dQ$

Here, D represents the diagnosis value, V_{RCP}(Q) represents the voltage value of the corresponding reference charge profile when the capacity is Q, and V_{RDP}(Q) represents the voltage value of the corresponding reference discharge profile when the capacity is Q.

The battery management apparatus 100 may further include a control unit 130. The control unit 130 may be configured to set a usage condition for the battery based on the diagnosis result.

If the state of the battery is diagnosed as a normal state, the control unit 130 may not change the usage condition for the battery. Conversely, if the state of the battery is diagnosed as an abnormal state, the control unit 130 may change the usage condition for the battery.

For example, the control unit 130 may reduce the maximum charge/discharge rate for the battery. As another example, the control unit 130 may reduce the charge end voltage of the battery. The charge end voltage may mean the end voltage allowed when charging the battery. As another example, the control unit 130 may increase the discharge end voltage of the battery. The discharge end voltage may mean the minimum voltage allowed when discharging the battery.

The rate of decrease of the maximum charge/discharge rate, the rate of decrease of the end voltage of the charge, or the rate of increase of the end voltage of the discharge may be determined to be proportional to the difference or ratio between the hysteresis characteristic value of the battery and the diagnosis value. For example, when the ratio of the hysteresis characteristic value of the battery to the diagnosis value is 1.1, the maximum charge/discharge rate may be set to decrease by a ratio of 1/1.1 compared to before.

The battery management apparatus 100 according to an embodiment of the present disclosure may prevent degradation or accelerated degradation of a battery by appropriately setting a usage condition of the battery based on the state diagnosis result for the battery.

The battery management apparatus 100 according to the present disclosure may be applied to a battery management system (BMS). That is, the BMS according to the present disclosure may include the battery management apparatus 100 described above. In this configuration, at least some of components of the battery management apparatus 100 may be implemented by supplementing or adding functions of the components included in a conventional BMS. For example, the profile obtaining unit 110, the diagnosing unit 120, the control unit 130 and the storage unit 140 of the battery management apparatus 100 may be implemented as components of the BMS.

The battery management apparatus 100 according to the present disclosure may be provided in the battery pack. That is, the battery pack 10 according to the present disclosure may include the above-described battery management apparatus 100 and at least one battery. Additionally, the battery pack may further include electrical components (relays, fuses, etc.) and a case.

FIG. 3 is a drawing illustrating an exemplary configuration of a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive terminal of the battery 11 through the first sensing line SL1, and to the negative terminal of the battery 11 through the second sensing line SL2. The measuring unit 12 may measure the voltage of the battery 11 based on the voltage measured from each of the first sensing line SL1 and the second sensing line SL2.

In addition, the measuring unit 12 may be connected to the current measurement unit A through the third sensing line SL3. For example, the current measurement unit A may be an ammeter or shunt resistor that may measure the charging current and discharging current of the battery 11. The measuring unit 12 may calculate the charging amount by measuring the charging current of the battery 11 through the third sensing line SL3. Additionally, the measuring unit 12 may calculate the discharging amount by measuring the discharging current of the battery 11 through the third sensing line SL3.

One end of an external device (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the external device may be a charging device, or a load such as a motor of an electric vehicle that receives power from the battery 11.

FIG. 4 is a drawing schematically illustrating a vehicle 1 according to still another embodiment of the present disclosure.

Referring to FIG. 4, the battery pack 10 according to an embodiment of the present disclosure may be included in the vehicle 1 such as an electric vehicle (EV) or a hybrid vehicle (HV). Here, the battery pack 10 described above may be applied to the battery pack 10. Additionally, the battery pack 10 may drive the vehicle 1 by supplying power to the motor through an inverter provided in the vehicle 1. Here, the battery pack 10 may include the battery management apparatus 100 according to an embodiment of the present disclosure. That is, the vehicle 1 may include the battery management apparatus 100. In this case, the battery management apparatus 100 may be an onboard device included in the vehicle 1.

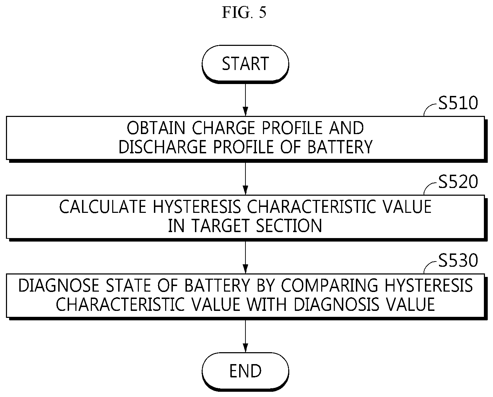

FIG. 5 is a drawing schematically illustrating a battery management method according to still another embodiment of the present disclosure.

Preferably, each step of the battery management method may be performed by the battery management apparatus 100. Hereinafter, for convenience of explanation, the content overlapping with the previously described content will be briefly described or omitted.

Referring to FIG. 5, in step S510, the profile obtaining unit 110 may obtain a charge profile CP and a discharge profile DP representing the charge and discharge characteristic of the battery.

The charge profile may represent the corresponding relationship between the voltage and capacity (or SOC: State of Charge, resistance) in the charging process of the battery. And, the discharge profile may represent the corresponding relationship between the voltage and capacity (or SOC, resistance) in the discharging process of the battery.

In step S520, the diagnosing unit 120 may calculate a hysteresis characteristic value based on voltage difference information between the charge profile CP and the discharge profile DP in the target section TS.

For example, the diagnosing unit 120 may be configured to determine the target section TS by comparing the capacity range (or SOC range, resistance range) of the charge profile CP with the capacity range (or SOC range, resistance range) of the discharge profile DP.

As another example, the target section TS may be predetermined.

The diagnosing unit 120 may be configured to calculate a hysteresis characteristic value based on an integral of a voltage difference between a voltage of the charge profile CP and a voltage of the discharge profile DP with respect to the target section TS.

In step S530, the diagnosing unit 120 may diagnose the state of the battery by comparing the hysteresis characteristic value with the diagnosis value.

In one embodiment, the diagnosing unit 120 may diagnose the state of the battery based on the difference between the hysteresis characteristic value and the diagnosis value. For example, if the difference between the hysteresis characteristic value and the diagnosis value is less than a preset first threshold value, the diagnosing unit 120 may be configured to diagnose the state of the battery as a normal state. As another example, if the difference between the hysteresis characteristic value and the diagnosis value is greater than or equal to the first threshold value, the diagnosing unit 120 may be configured to diagnose the state of the battery as an abnormal state.

In another embodiment, the diagnosing unit 120 may diagnose the state of the battery based on the ratio between the hysteresis characteristic value and the diagnosis value. For example, if the ratio of the hysteresis characteristic value to the diagnosis value is less than a preset second threshold value, the diagnosing unit 120 may be configured to diagnose the state of the battery as a normal state. As another example, if the ratio of the hysteresis characteristic value to the diagnosis value is greater than or equal to the second threshold value, the diagnosing unit 120 may be configured to diagnose the state of the battery as an abnormal state.

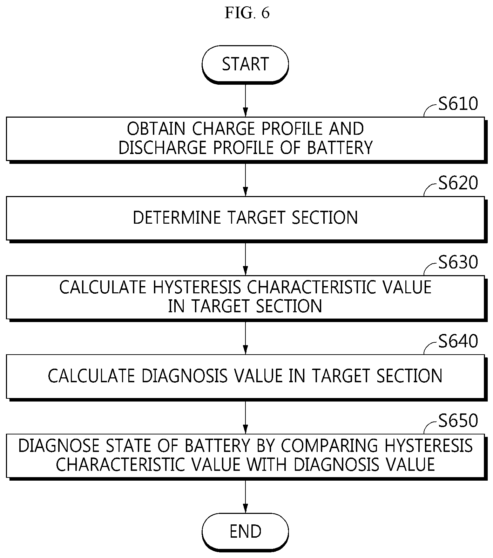

FIG. 6 is a drawing schematically illustrating a battery management method according to still another embodiment of the present disclosure.

Any content that overlaps with the content previously described with reference to FIG. 5 is omitted or briefly explained.

Referring to FIG. 6, in step S610, the profile obtaining unit 110 may obtain a charge profile CP and a discharge profile DP representing the charge and discharge characteristic of the battery.

In step S620, the diagnosing unit 120 may determine the target section TS by comparing the capacity range of the charge profile CP and the capacity range of the discharge profile DP.

For example, the diagnosing unit 120 may be configured to determine a target section TS by comparing a capacity range of the charge profile CP with a capacity range of the discharge profile DP. The target section TS may be all or part of a capacity section common to the charge profile CP and the discharge profile DP.

In step S630, the diagnosing unit 120 may calculate a hysteresis characteristic value based on voltage difference information between the charge profile CP and the discharge profile DP in the target section TS.

In step S640, the diagnosing unit 120 may calculate a diagnosis value in the target section TS.

In one embodiment, the diagnosing unit 120 may determine a reference value mapped to one reference capacity section corresponding to the target section TS among a plurality of reference capacity sections as the diagnosis value.

In another embodiment, the diagnosing unit 120 may calculate a diagnosis value based on a preset reference charge profile and reference discharge profile.

For example, the diagnosing unit 120 may be configured to determine a diagnosis value based on an integral of a voltage difference between the voltage of the reference charge profile and the voltage of the discharge profile DP with respect to the target section TS.

For example, the diagnosing unit 120 may calculate the voltage difference between the voltage value of the reference charge profile and the voltage value of the reference discharge profile corresponding to the same capacity within the target section TS. Then, the diagnosing unit 120 may determine the integral for the voltage difference in the target section TS as the diagnosis value.

In step S650, the diagnosing unit 120 may diagnose the state of the battery by comparing the hysteresis characteristic value with the diagnosis value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of symbols]

1: electric vehicle
10: battery pack
100: battery management apparatus
110: profile obtaining unit
120: diagnosing unit
130: control unit
140: storage unit

## Claims

1. A battery management apparatus, comprising:
a profile obtaining unit configured to obtain a charge profile and a discharge profile representing a charge and discharge characteristic of a battery; and
a diagnosing unit configured to calculate a hysteresis characteristic value based on voltage difference information between the charge profile and the discharge profile in a target section and to compare the hysteresis characteristic value with a diagnosis value to diagnose a state of the battery.

2. The battery management apparatus according to claim 1,
wherein the diagnosing unit is configured to determine the target section by comparing a capacity range of the charge profile with a capacity range of the discharge profile.

3. The battery management apparatus according to claim 2,
wherein the diagnosing unit is configured to determine all or part of a capacity section common to the charge profile and the discharge profile as the target section.

4. The battery management apparatus according to claim 1,
wherein the target section is predetermined.

5. The battery management apparatus according to claim 1,
wherein the diagnosing unit is configured to calculate the hysteresis characteristic value based on an integral of a voltage difference between a voltage of the charge profile and a voltage of the discharge profile for the target section.

6. The battery management apparatus according to claim 1, further comprising a storage unit,
wherein the storage unit stores a lookup table in which a plurality of reference capacity sections and a plurality of diagnosis values are mapped one-to-one, and
wherein the diagnosing unit determines a reference value mapped to one reference capacity section corresponding to the target section among the plurality of reference capacity sections as the diagnosis value.

7. The battery management apparatus according to claim 1,
wherein the diagnosing unit is configured to calculate the diagnosis value based on a preset reference charge profile and a preset reference discharge profile.

8. The battery management apparatus according to claim 7,
wherein the diagnosing unit is configured to determine the diagnosis value based on an integral of a voltage difference between a voltage of the reference charge profile and a voltage of the discharge profile for the target section.

9. The battery management apparatus according to claim 1,
wherein the diagnosing unit diagnoses the state of the battery as a normal state when a difference between the hysteresis characteristic value and the diagnosis value is less than a preset first threshold value, and
wherein the diagnosing unit diagnoses the state of the battery as an abnormal state when the difference between the hysteresis characteristic value and the diagnosis value is greater than or equal to the first threshold value.

10. The battery management apparatus according to claim 1,
wherein the diagnosing unit diagnoses the state of the battery as a normal state when a ratio of the hysteresis characteristic value to the diagnosis value is less than a preset second threshold value, and diagnoses the state of the battery as an abnormal state when the ratio of the hysteresis characteristic value to the diagnosis value is greater than or equal to the preset second threshold value.

11. The battery management apparatus according to claim 1, further comprising a control unit,
wherein the control unit is configured to set a usage condition for the battery based on the diagnosis result.

12. A battery pack, comprising the battery management apparatus according to any one of claims 1 to 11.

13. A vehicle, comprising the battery management apparatus according to any one of claims 1 to 11.

14. A battery management method, comprising:
obtaining a charge profile and a discharge profile representing a charge and discharge characteristic of a battery;
calculating a hysteresis characteristic value based on voltage difference information between the charge profile and the discharge profile in a target section; and
comparing the hysteresis characteristic value with a diagnosis value to diagnose a state of the battery.
